# EUROPEAN PATENT APPLICATION

(11) **EP 2 953 264 A2**
(43) Date of publication of application: **09.12.2015**
(21) Application number: 15170812.0
(22) Date of filing: 05.06.2015
(51) Int. Cl.: H03K 4/94, H03K 7/08, H05B 33/08, B64D 11/00

(54) **PULSE WIDTH MODULATOR FOR USE IN AVIATION**

(30) Priority: 06.06.2014 GB 201410111
(71) Applicant: Aim Aviation Limited, Bournemouth, Dorset BH1 4PD (GB)
(72) Inventor: STARTIN, Rolf Peter, Bournemouth, Dorset BH1 4PD (GB); BELL, Matthew Stuart, Bournemouth, Dorset BH1 4PD (GB)
(74) Representative: D Young & Co LLP

(57) **Abstract**

A pulse width modulator for use in avionics is described. This comprises an input operable to receive a direct current input and an output switch controlled to provide a pulse train having a duty cycle, whereby the output switch is configured such that each pulse within the pulse train has at least one of a sloping rising or falling edge.

## Description

### BACKGROUND

### Field of the Disclosure

The present invention relates in general, but not exclusively, to a pulse width modulator for use in aviation.

### Description of the Related Art

The "background" description provided herein is for the purpose of generally presenting the context of the disclosure. Work of the presently named inventors, to the extent it is described in the background section, as well as aspects of the description which may not otherwise qualify as prior art at the time of filing, are neither expressly or impliedly admitted as prior art against the present invention.

In aircraft individual passenger seats are equipped with lighting. This lighting creates an ambience for the individual passenger as well as providing lighting to read. During long haul flights, the ambience in the cabin is changed as the aircraft travels through different time zones. For example, the cabin lights are dimmed during periods when travelling at night.

In recent times, the bulbs for these passenger lights have moved from a heated filament type bulb to a Light Emitting Diode (LED) type bulb. These LED type bulbs are controlled digitally.

It is possible to control the individual passenger lighting to dim in accordance with the cabin lights. However, this digital control is realised by linking the control of the individual passenger lighting to the control of the cabin lights. This typically requires one digital channel in the passenger's entertainment unit to be dedicated to controlling the individual passenger light. However, this removes one channel from the user's entertainment system. Further in the field of aviation, given the safety and certification requirements, there is a complex process of connecting a third party lighting system to an aircraft. Also, in the field of avionics, electromagnetic interference is carefully managed. This is especially the case around radio frequency bands. This is for safety reasons. This makes digital power control of any device, not just lighting, very difficult.

It is an aim of embodiments of the present invention to address these issues.

### SUMMARY

According to an aspect of the invention, there is provided a pulse width modulator for use in avionics comprising an input operable to receive a direct current input and an output switch controlled to provide a pulse train having a duty cycle, whereby the output switch is configured such that each pulse within the pulse train has at least one of a sloping rising or falling edge.

When the predetermined duty cycle is changed to a second, different, duty cycle, the duty cycle may be changed incrementally towards the second duty cycle.

Each increment of change may occur at a predetermined period of time.

The pulse width modulator may comprise a sensor input operable to receive data, from a sensor, and the duty cycle is determined in accordance with the received data.

In this case, the pulse width modulator may comprise a memory configured to store a look up table, wherein the look up table has the received data associated with the corresponding duty cycle.

The received data may be logarithmically associated with the corresponding duty cycle.

The pulse width modulator may comprise a transceiver operable to connect to a second pulse width modulator, the transceiver operable to provide to the second pulse width modulator data indicative of the duty cycle.

The pulse width modulator may comprise a transceiver operable to connect to a second pulse width modulator, the transceiver operable to receive from the second pulse width modulator data indicative of the duty cycle.

There is also provided a system comprising a pulse width modulator according to any preceding claim connected to an electrical device.

The electrical device may be a light box comprising one or more lights.

The system may comprise a light sensor connected to the pulse width modulator.

According to another aspect, there is provided a method of performing pulse width modulation for use in avionics comprising receiving a direct current input and controlling an output switch to provide a pulse train having a duty cycle, whereby each pulse within the pulse train has at least one of a sloping rising or falling edge.

According to another aspect, there is provided firmware comprising microprocessor readable instructions which, when loaded onto a microprocessor, configures the microprocessor to perform the method of the above.

The foregoing paragraphs have been provided by way of general introduction, and are not intended to limit the scope of the following claims. The described embodiments, together with further advantages, will be best understood by reference to the following detailed description taken in conjunction with the accompanying drawings.

### BRIEF DESCRIPTION OF THE DRAWINGS

A more complete appreciation of the disclosure and many of the attendant advantages thereof will be readily obtained as the same becomes better understood by reference to the following detailed description when considered in connection with the accompanying drawings, wherein:
Figure 1 shows a diagram of a device according to embodiments;
Figure 2 shows a system with several devices of Figure 1 coupled to a light sensor;
Figure 3 shows a system with several devices of Figure 1 coupled in a master/slave relationship;
Figure 4 shows the light sensor used in the system of Figure 2;
Figure 5 shows the relationship between the light intensity in the cabin and the pulse width modulation of the device in Figure 1;
Figure 6 shows a schematic diagram of the shape of a pulse within the pulse width modulated signal in Figure 5;
Figures 7A-7E shows an oscilloscope output of the shape of a pulse shown schematically in Figure 6;
Figure 8 shows a flowchart of operation of the controller in the device of Figure 1;
Figures 9A-9C shows the Electromagnetic Interference emissions from the device of Figure 1; and
Figure 10 shows a graphical representation of the Look-Up table.

### DESCRIPTION OF THE EMBODIMENTS

Referring now to the drawings, wherein like reference numerals designate identical or corresponding parts throughout the several views.

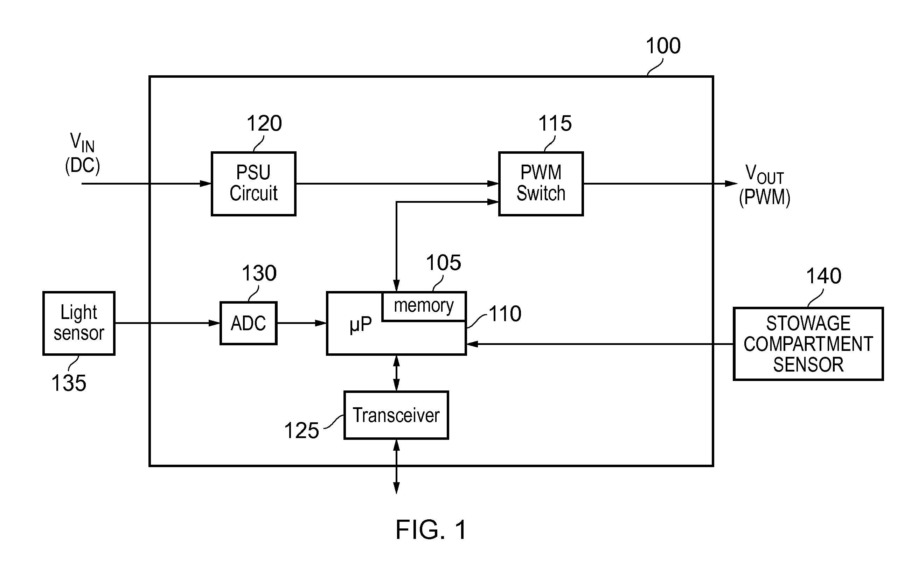

Referring to Figure 1, a pulse width modulator device 100 (hereinafter termed "a device") is shown. In an aircraft, the device 100 will be provided either with each seat in an aircraft cabin or will be provided for an area within the aircraft cabin. The device has several input lines and several output lines which are connected to other apparatuses external to the device 100. The device 100 comprises a power supply unit 120. The power supply unit 120 receives a direct current (DC) voltage from an external power supply (not shown). In embodiments, the external power supply is provided by a switched mode/filtered power supply located in the aircraft in which the device 100 is fitted. This external power supply is between 20.5V and 32.2V, and is typically 28V. The power supply unit 120 includes an inline fuse which will isolate the external power supply in the event of a short circuit or overload condition. Further, the power supply unit 120 provides protection against reverse polarity and power spike situations.

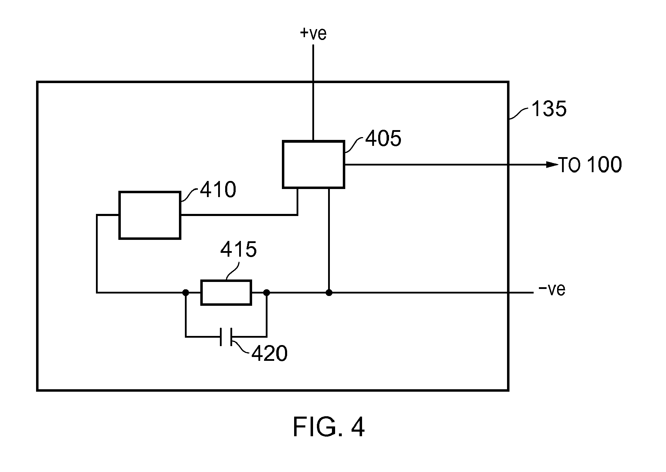

The device 100 also comprises an analogue to digital converter (hereinafter termed "ADC") 130. The ADC 130 is connected to a light sensor 135. In embodiments, the light sensor 135 is external to the device 100. However, the invention is not so limited and, as such, the light sensor 135 may be incorporated into the device 100. The ADC receives an analogue voltage from the light sensor 135. This analogue voltage indicates the ambient light within the cabin of the aircraft as will be explained with reference to Figure 4. The ADC 130 is a 13-bit ADC meaning that the analogue voltage output from the light sensor 135 is converted into a 13 bit digital number. The function of the ADC 130 will be described later.

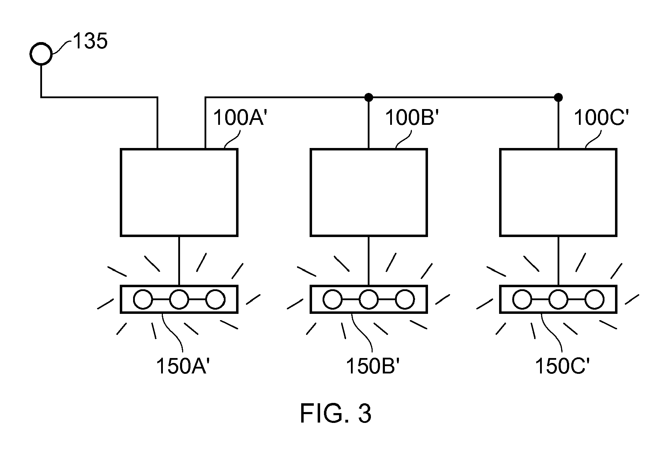

The device 100 also comprises a controller 110. The output of the ADC 130 is fed into the controller 110. Also fed into the controller 110 is an output from a sensor on stowage compartment 140. The optional sensor on the stowage compartment 140 senses whether the stowage compartment is opened or closed. This will be explained later. Further connected to the controller 110 are a transceiver 125 and a pulse width modulator switch 115. The transceiver 125 is used to communicate with other devices 100 in a master/slave configuration shown in Figure 3 and will be explained later. The pulse width modulator switch 115 is, in embodiments, a Metal Oxide Semiconductor Field Effect Transistor (MOSFET).

The controller 110 has memory 105. The memory 105 has stored therein computer readable instructions (sometimes called firmware). These instructions are formed of computer code. In embodiments, the memory 105 is read-only memory that cannot be re-written. This ensures integrity of the code which is important in the context of aviation. Typically, the memory 105 is solid-state memory, although the invention is not so limited.

Further, the memory 105 stores a look-up table. The look-up table provides, for any value of ambient light detected by the light sensor 135, a corresponding ratio of time on/time off for the pulse width modulator. The look-up table will be described later.

The pulse width modulator switch 115, in addition to receiving instructions from the controller 110 also receives its power from the power supply unit 120. The output of the pulse width modulator switch 115 is a pulse width modulated signal which has a trapezoidal shape. The pulse width modulator switch 115 is a power MOSFET. The pulse width modulator switch 115 switches at a frequency of 420Hz. The pulse width modulator switch 115 is, in embodiments, connected to an external light assembly (not shown). By switching at this frequency, any flicker at low light intensities will not be perceptible to the user. However, it is counter-intuitive to switch a pulse width modulator switch 115 in an avionic environment at such a high frequency. This is because, typically, the higher the frequency of switching, the higher the electromagnetic interference. Therefore, typically in avionics, devices are switched at a low frequency to reduce the electromagnetic interference. The maximum output current provided by the device 100 is 3A.

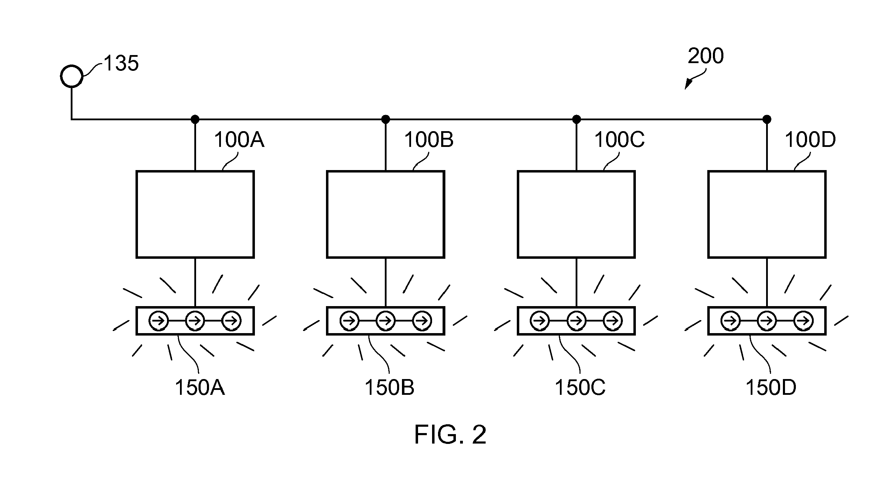

Referring to Figure 2, a first system 200 is shown where the light sensor 135 is connected to a plurality of devices 100. This enables one light sensor 135 to provide ambient light levels to a plurality of devices 100. This is shown in Figure 2 where one light sensor 135 is connected to four devices 100A-100D. Each of the devices 100A-100D is connected to respective banks of lights 150A-150B. Each respective bank of lights 150A-150D are so-called feature lights made of Light Emitting Diode type bulbs and are located around a passenger seat in an aircraft cabin. These feature lights provide lighting around cabin furniture, and should vary with the ambient light within the aircraft cabin. Therefore, by using the light sensor 135 to detect the ambient light in a region of the cabin, it is possible to set the light provided by the feature lights located within this region. It should be noted that in this configuration, although the devices 100A-100D receive the same output from the light sensor 135, the devices 100A-100D otherwise operate independently of one another.

Referring to Figure 3, a second system 300 is shown where the light sensor 135 is connected to a single device 100A' and that single device 100A' is connected to a plurality of other devices 100B'-100C'. In this arrangement, the single device 100A' is the so-called "master" device and the other devices 100B'-100C' are the so-called "slave" devices. In other words, the single device 100A' controls the operation of the other devices 100B'-100C'. This will be explained later. Each of the devices 100A'-100C' are connected to respective banks of feature lights 150A'-150C'.

Referring to Figure 4, an embodiment of the light sensor 135 is shown. The light sensor 135 comprises a signal smoothing circuit 405. The signal smoothing circuit 405 has the positive and negative power supply input into the circuit 405. Similar to the device 100, the external power supply to the signal smoothing circuit 405 is provided by a switched power supply located within the aircraft. The signal smoothing circuit 405 provides power to the light sensor circuit 135 and removes any transient or reverse polarity issues that may arise. Further, the signal smoothing circuit 135 provides the analogue voltage to the device 100. This analogue voltage is indicative of the ambient light within the aircraft cabin.

The light sensor 135 also comprises a light photo sensor 410. The light photo sensor 410 has a phototransistor that peaks in the human luminosity curve and so provides a response similar to the human eye. A typical example of the light photo sensor 410 is an APDS9002 made by Avago Technology ®. Also connected to the light photo sensor 410 is a resistor 415. This, in embodiments, is 51kΩ and is used to generate the voltage output from the light photo sensor 410 (the APDS9002 package actually outputs a current waveform). A capacitor 420 is provided in parallel to the resistor 410 to remove transient voltages. The capacitor 420 has a value of 0.1 µF.

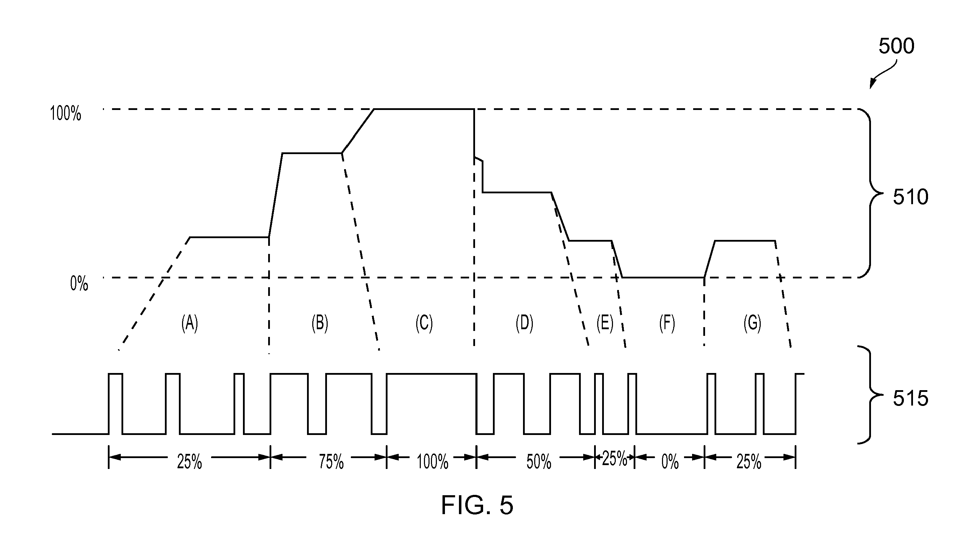

Referring to Figure 5, a graph 500 is shown. This graph 500 shows the ambient light levels 510 as detected by the light sensor 135. These ambient light levels are shown as a percentage of a range and are provided to the device 100. The range of ambient light levels range from 0% (darkness) to 100% (very bright). The ambient light levels are capped at 200 Lux because it is considered in-perceivable to a human to distinguish between different values over 200 Lux in an aircraft cabin.

In region A, the light sensor 135 detects that the ambient light is 25% of its maximum level. The light sensor 135 provides a voltage indicative of this value of ambient light. The ADC 130 within the device 100 converts this voltage to a binary number. The controller 110 interrogates the look-up table located within memory 105 and determines an appropriate ratio of time on/time off for that binary number. In other words, the look-up table provides appropriate ratios of time on/time off for different values of ambient light. In embodiments, the binary numbers increase linearly with the ambient light. In other words, there is a linear relationship between the binary numbers and the ambient light. However, as the human eye is more sensitive to changes in light when the ambient level of light is low, it is preferred to have a logarithmic relationship between the binary numbers and the ambient light. In other words, at low ambient light levels, the resolution of changes in ambient light levels increases. Conversely, in medium to high light intensity levels, where the changes in light levels are not so easily differentiated, the resolution of changes in ambient light levels is lower.

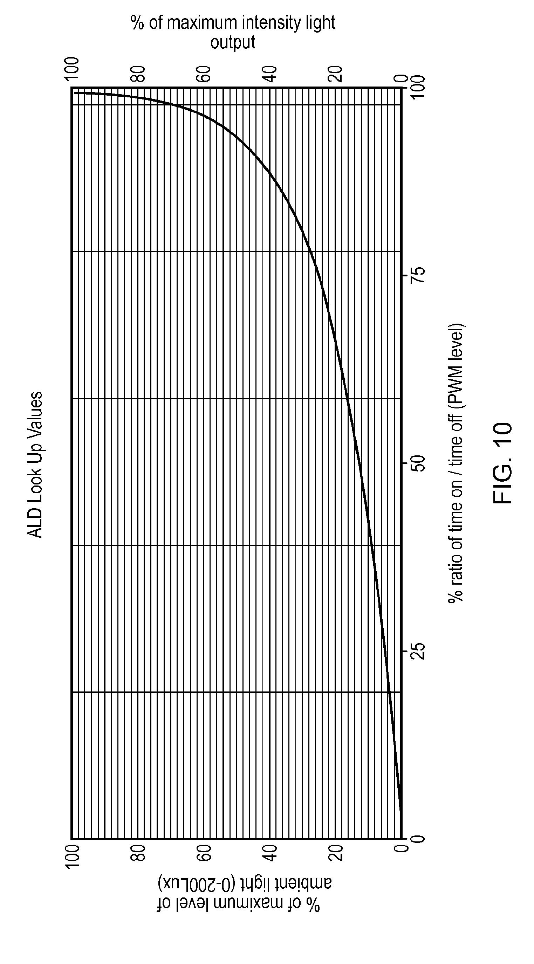

A graphical representation of the Look-Up table is shown in Figure 10. On the left vertical axis the percentage of maximum ambient light level (between 0 and 200 Lux) is shown. On the right hand vertical axis there is shown the percentage of maximum output light from the light bulb (which is an LED in the specific embodiment). These percentage values are the same. The horizontal axis shows the percentage ratio of time on/time off which is the pulse width modulation level.

As is seen in region A of Figure 5, the controller 110 switches the pulse width modulation switch 115 to have a 25% ratio of time on/time off. Although not immediately apparent from Figure 5, each pulse is trapezoidal in shape. In other words, the rise and fall time of the pulse is sloped rather than substantially vertical. The effect of this will become apparent later, but by sloping the rise and/or fall time of the pulse, the electromagnetic interference is reduced.

In region B, the light sensor 135 detects that the ambient light is 75% of its maximum level. Again, after interrogating the look-up table (the graphical representation of which is shown in Figure 10), the controller 110 switches the pulse width modulation switch 115 to have a 98.8% ratio of time on/time off. This is because the user's eye is more sensitive to low light levels and so the look up table provides an exponential relationship between the ambient light level and the ratio of time on/time off as explained above.

It is important to note that the transition from 25% of the maximum level to 75% of the maximum level is performed over a period of time. This is indicated by the slope between region A and region B in Figure 5, but actually occurs between any changes in lighting levels that are noticeable to the passenger. Typically, the transition between two levels takes place over several seconds to ensure a smooth transition in the lighting levels. For example, in this case, the transition between 25% of the maximum level and 75% of the maximum level takes place over 2.5 seconds. This avoids a sharp change in the lighting levels which may be uncomfortable for the passenger. This transition is achieved by increasing the value output to the pulse width modulation switch 115 by one bit every 125ms. In other words, the value of the duty cycle will increase very gradually between the two levels. Of course, if the transition was from a higher level to a lower level, the value output to the pulse width modulator switch 115 would be reduced by one bit every 125ms. Further, the transition may be made quicker or longer by shortening or lengthening the period at which one bit is changed and/or by increasing or decreasing the change at each period.

In region C, the light sensor 135 detects that the ambient light is 100% of its maximum level. Therefore, the controller 110 switches the pulse width modulation switch 115 to be on. In region D, the light sensor 135 detects that the ambient light is 50% of its maximum level. Again, after interrogating the look-up table, the controller 110 switches the pulse width modulation switch 115 to have a 94.1% ratio of time on/time off. In region E, the light sensor 135 detects that the ambient light is 25% of its maximum level. Again, after interrogating the look-up table, the controller 110 switches the pulse width modulation switch 115 to have a 74.6% ratio of time on/time off. In region F, the light sensor 135 detects that the ambient light is 0% of its maximum level (i.e. it is dark). Therefore, the controller 110 switches the pulse width modulation switch 115 to be off (or at least to a predetermined minimum value). In region G, the light sensor 135 detects that the ambient light is 25% of its maximum level. Again, after interrogating the look-up table, the controller 110 switches the pulse width modulation switch 115 to have a 74.6% ratio of time on/time off.

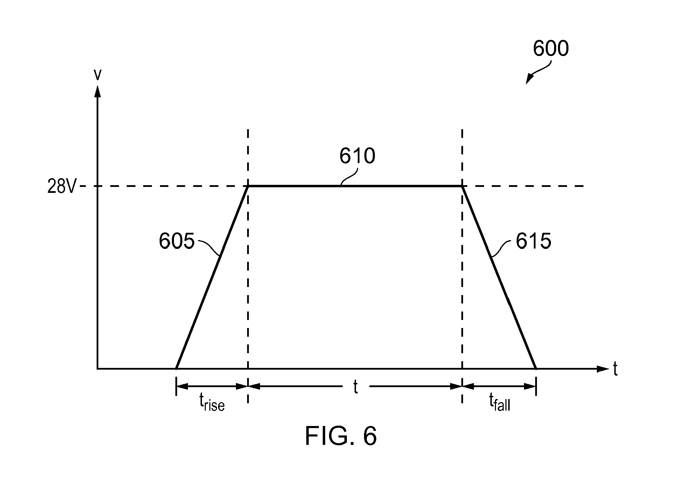

Referring to Figure 6, a single pulse 600 from area 515 of Figure 5 is shown in more detail. As is seen, although the representation of the pulse in Figure 5 appears to have vertical edges and thus a rectangular shape, the pulse actually has sloping edges and is thus a trapezoidal shape. Specifically, the rising edge 605 has a rise time, tᵣᵢₛₑ, of between 10 and 100µs before reaching the peak steady voltage 610 of, in this case, 28V. Further, the falling edge 615 has a fall time, t_{fall}, of between 10 and 100µs. By having a trapezoidal shape, the electromagnetic interference produced by the device 100 is very low. This is because having a slope on the rising and falling edge of the pulse (rather than the traditional vertical edge) reduces the number of harmonics generated by the rising and falling edge and thus reduces the amount of electromagnetic interference generated by the device 100. In embodiments, the rising edge will be between 50 and 60µs. This range is advantageous because whilst it is useful to have a gradual slope on the rising and falling edge of the pulse to reduce the electromagnetic interference, the introduction of a slope means that the overall time for the pulse is increased and thus the frequency of the pulse width modulation signal is reduced. This is particularly relevant where the duty cycle of the pulse width modulated signal is around 50%. This is because for any pulse width modulation frequency, the pulse would normally be on for 50% of the time of the time and would be off for 50% of the time. However, if the time for the rising and falling edge is too high, a 50% duty cycle will not be achieved. Therefore, the range of between 50µs and 60µs for either or both of the rising and falling edge is a particularly useful compromise.

In order to provide the slope on the rising and/or falling edge of the pulse, the controller 110 gradually switches on the pulse width modulator switch 115. In other words, the controller 110 gradually increases the gate voltage on the MOSFET so that the MOSFET operates in the triode mode for a period of time. Normally in a pulse width modulator, the output transistor is driven from the cutoff mode (i.e. the transistor being "off") to the active mode (i.e. the transistor being "on") as quickly as possible. However, in embodiments, the time taken for the transistor to switch from the cutoff mode to the active mode is tᵣᵢₛₑ and the time taken for the transistor to switch from the active mode to the cutoff mode is t_{fall}. During this period, the controller 110 linearly increases or decreases the gate voltage to linearly switch on or switch off the MOSFET. The effect of this linear increase or decrease in gate voltage is a slope on the rise and/or falling edge of the pulse.

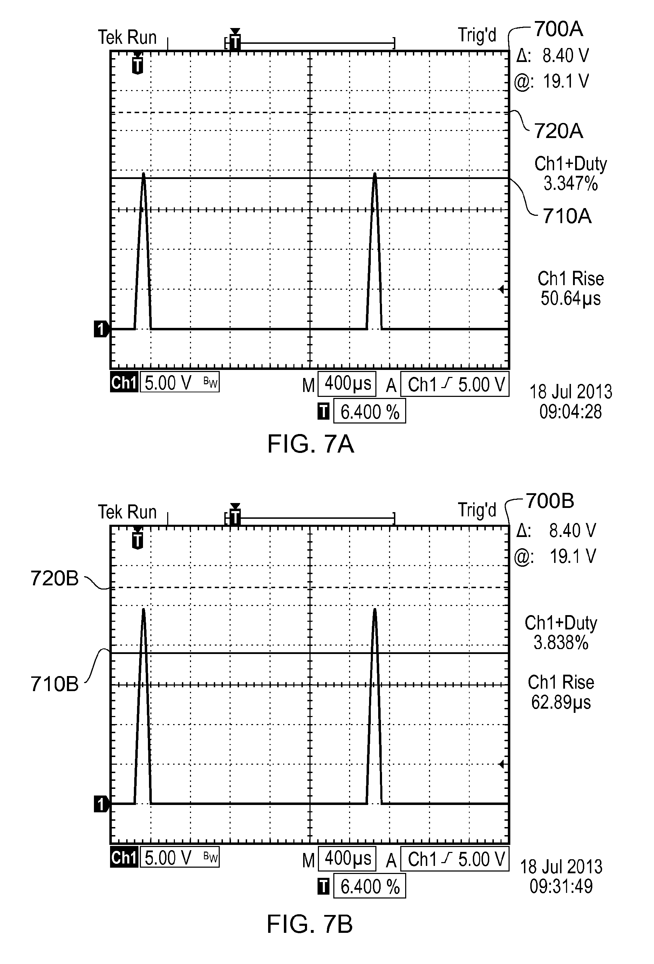

Referring to Figure 7A an oscilloscope display 700A is shown. This display 700A has a solid black line 710A which is the turn on voltage point of the bank of lights. Further, the DC limit of the bank of lights is shown by the dotted lines 720A. In Figure 7A, the bank of lights will be just switching on (as the voltage is just above black solid line 710A). Further, the duty cycle of the pulse width modulation switch 115 is 3.347%. Further, the rise (and fall) time of the edge is 50.64µs.

Referring to Figure 7B an oscilloscope display 700B is shown. This display 700B has a solid black line 710B which is the turn on voltage point of the bank of lights. Further, the DC limit of the bank of lights is shown by the dotted lines 720B. In Figure 7B, the bank of lights will be in conduction and will be barely visible. Another advantage with the sloped rising and falling edges is that for low duty cycles (i.e. the pulse width modulation switch is mostly off), the very short periods for which the pulse width modulation switch 115 is on are not seen as transient spikes as can occur with very sharp rising and falling edges. This means that the device 100 in which the pulse width modulation switch 115 generates sloping rising and falling edges has much better control for low output power situations. This is particularly useful when the device 100 controls lights because at low light levels, the human eye is more sensitive and so better control is desirable. In the case of Figure 7B, the duty cycle of the pulse width modulation switch 115 is 3.838%. Further, the rise (and fall) time of the edge is 62.89µs.

It should be noted here that using a conventional sharp rising and falling edge, the bank of lights would not operate at all as the output from a pulse width modulator would be seen as a transient spike.

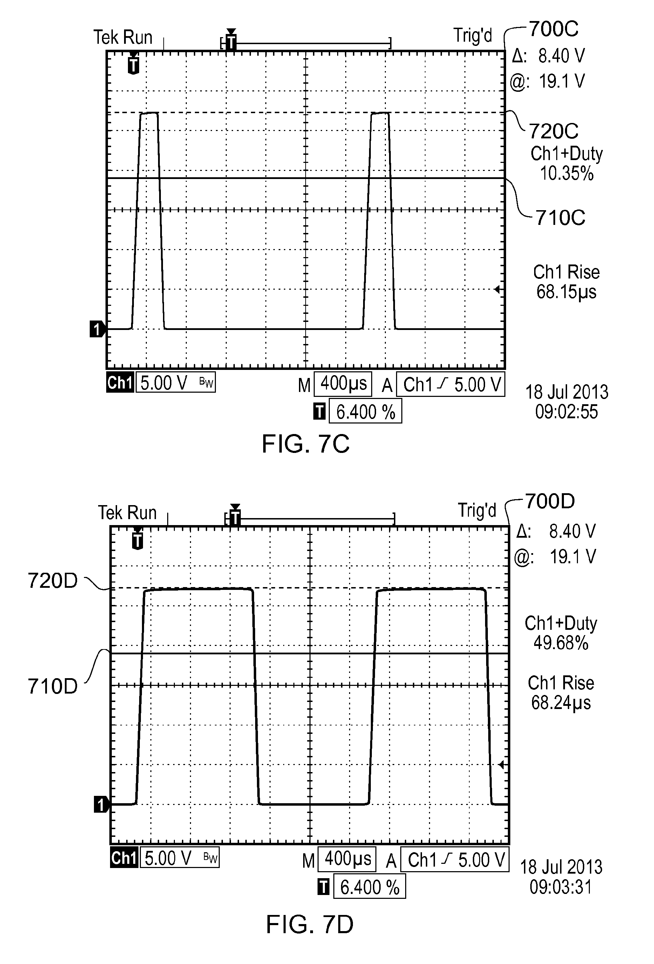

Referring to Figure 7C, an oscilloscope display 700C is shown. This display 700C has a solid black line 710C which is the turn on voltage point of the bank of lights. Further, the DC limit of the bank of lights is shown by the dotted lines 720C. In Figure 7C, the bank of lights will operate at about 10% of maximum brightness. This is because the bank of lights are receiving the full 28V DC for 10.35% of the time. This means that the duty cycle of the pulse width modulation switch 115 is 10.35%. Further, the rise (and fall) time of the edge is around 68 µs at 68.15µs.

Referring to Figure 7D, an oscilloscope display 700D is shown. This display 700D has a solid black line 710D which is the turn on voltage point of the bank of lights. Further, the DC limit of the bank of lights is shown by the dotted lines 720D. In Figure 7D, the bank of lights will operate at about 50% of maximum brightness. This is because the bank of lights are receiving the full 28V DC for 49.68% of the time. This means that the duty cycle of the pulse width modulation switch 115 is 49.68%. Further, the rise (and fall) time of the edge is around 68 µs at 68.24µs.

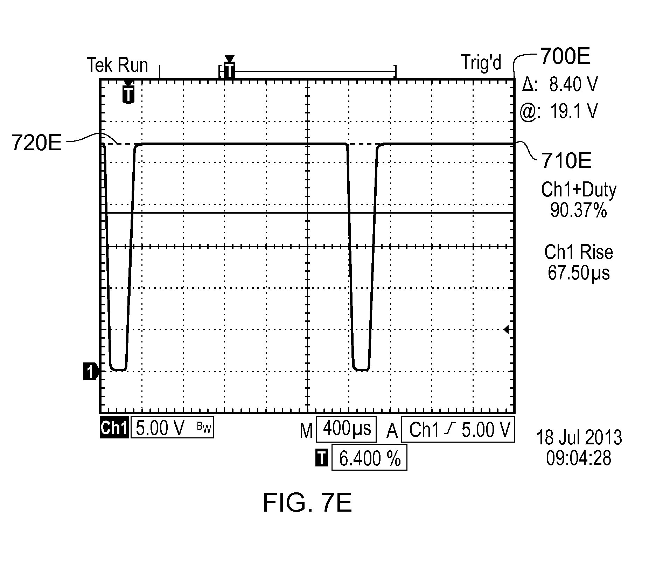

Referring to Figure 7E, an oscilloscope display 700E is shown. This display 700E has a solid black line 710E which is the turn on voltage point of the bank of lights. Further, the DC limit of the bank of lights is shown by the dotted lines 720E. In Figure 7E, the bank of lights will operate at about 90% of maximum brightness. This is because the bank of lights are receiving the full 28V DC for 90.37% of the time. This means that the duty cycle of the pulse width modulation switch 115 is 90.37%. Further, the rise (and fall) time of the edge is around 68 µs at 67.50µs. Although the bank of lights is operating at 90% of full power, in reality, the human eye would not differentiate between 90% of full power and 100% of full power. This again indicates that a logarithmic relationship for the resolution of changes between light levels is useful.

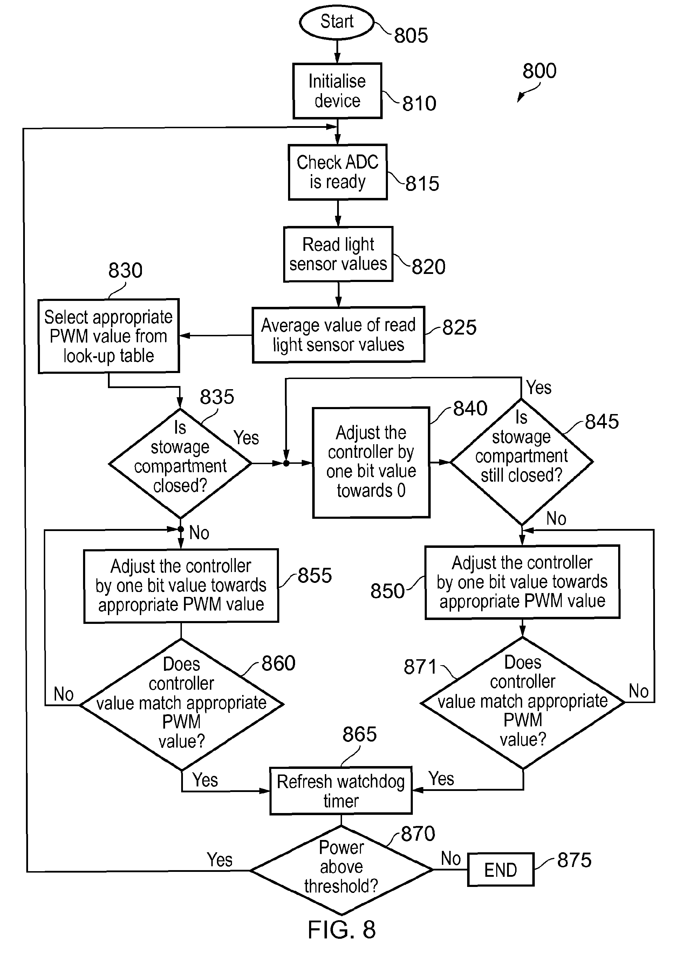

Referring to Figure 8, a flowchart 800 describing the operation of the device 100 and the first and second systems is described.

The flowchart 800 starts at step 805. This start step occurs when power is first applied to the device 100. After the device 100 has started, an initialisation step 810 is carried out. During the initialisation step, the timers within the firmware, such as the watchdog timer, are set up. Also, the ADC 130 is setup and checked. The initialisation step is standard in any device that receives external signal and is controlled by firmware.

After the device 100 is initialised, the ADC 130 is checked to confirm that it is ready to receive readings from the light sensor 135. This is step 815. After the ADC 130 is ready, the values from the light sensor 135 are read. In embodiments, 64 consecutive values of light sensor reading are captured. This is step 820. The average light sensor value is then determined in step 825. By obtaining the average light sensor value, the effect of any transient changes in ambient light is reduced.

The average light sensor value is used to interrogate the look-up table. The appropriate value for the pulse modulation switch is selected from the look-up table. This is step 830. A check is then made to see if the stowage compartment which contains a light from the light box is closed. This is step 835. In particular, a check is made to see if an infra-red sensor located within the stowage compartment indicates that the stowage compartment is open or closed.

If the stowage compartment is closed, then the lighting is turned off so that unwanted light bleed is not present. Therefore, to reduce un-necessary lighting within the cabin, the controller 110 switches the light box off. It may be possible for the controller 110 to instantly switch the light box off. However, this rapid change in lighting conditions can be unpleasant for the passenger. Therefore, and as explained above, the controller 135 gradually reduces the lighting level of the light box. Specifically, the controller 110 reduces the pulse width modulated switch value by 1 bit. This is step 840. The controller 110 checks whether the stowage compartment is still closed. If the stowage compartment is still closed, the "yes" path is followed and the controller 110 reduces the pulse width modulated switch value by 1 bit. This check occurs every 16ms, in embodiments. If the result of the check is that the stowage compartment is now open, the "no" path is followed and the controller 110 increases or decreases the pulse width modulated switch value by 1 bit towards the desired value retrieved from the look-up table. This is step 850. After 16ms the controller 110 checks whether the pulse width modulated switch value matches the desired value retrieved from the look-up table (step 871). If the pulse width modulated switch values does not match the desired value, then the process returns to step 850. However, if the pulse width modulated switch value does match the retrieved value, then the yes path is followed. The watchdog timer set during the initialisation step (step 810) is reset (step 865). The watchdog timer is provided so that after a certain threshold time, if the watchdog timer is not reset, then a fault within the code is deemed to have occurred and the device 100 will receive a full system rest (i.e. return to start 805) for safety.

Let us return to step 835. If the stowage compartment is open then the no path is followed. The pulse width modulated switch value is increased or decreased by one bit towards the desired value. This is step 855. After 125ms the controller 110 checks whether the pulse width modulated switch value matches the desired value retrieved from the look-up table. This is step 860.

If the pulse width modulated switch values does not match the desired value, then the no process returns to step 855. However, if the pulse width modulated switch values does match the desired value, then the yes path is followed and the watchdog timer is reset in step 865.

After the watchdog timer is reset, a check is made to ensure that the power to the device 100 is within operational limits. This is step 870. If the power to the device 100 is not within operational limits, the process ends as the device 100 cannot operate. This is step 875. However, if the power to the device 100 is within operational limits, the yes path is followed and the process returns to step 815 to commence the main loop again.

The above device 100 is described as a stand-alone device or in a system like the second system, where the light sensor 135 is connected to the device 100. However, in the third system, one device is connected to one or more other devices in a master/slave relationship. In this system, the light sensor 135 is connected to the master device only. Therefore, the master device performs all the steps of Figure 8 whereas the slave device(s) perform all the steps of Figure 8 except steps 820, 825 and 830. Instead of reading the light sensor values, the master device passes the appropriate pulse width modulated signal value (obtained in step 830) to the slave devices. The slave devices control the output to the light box on the basis of the light sensor value provided by the master device.

It is possible to reduce the overall electromagnetic interference further. In the above description, it is envisaged that after the process described in Figure 8 ends, the clock driving the device 100 is switched off until either a predetermined period of time elapses, or another device provides an interrupt. Moreover, the clock may be disabled at other times during the process of Figure 8. For example, the clock may be disabled after the yes path is followed in step 870, and may be enabled when the ADC is to be checked after a predetermined period of time or an interrupt is provided.

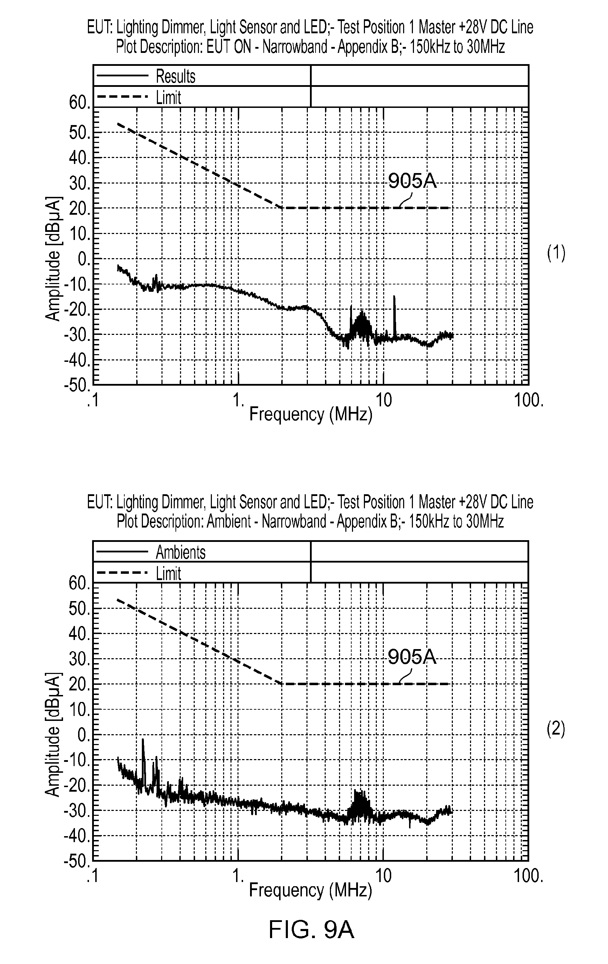

Figure 9A shows the electromagnetic interference within the band 150kHz to 30MHz for the device 100 in operation at +28V DC on the master line. In particular, Figure 9A (1) shows the EMI when the device is operational and Figure 9A (2) shows the EMI when the device is not operational. As can be seen, the EMI with the device 100 switched on is well below the permitted level marked by the dotted line 905A.

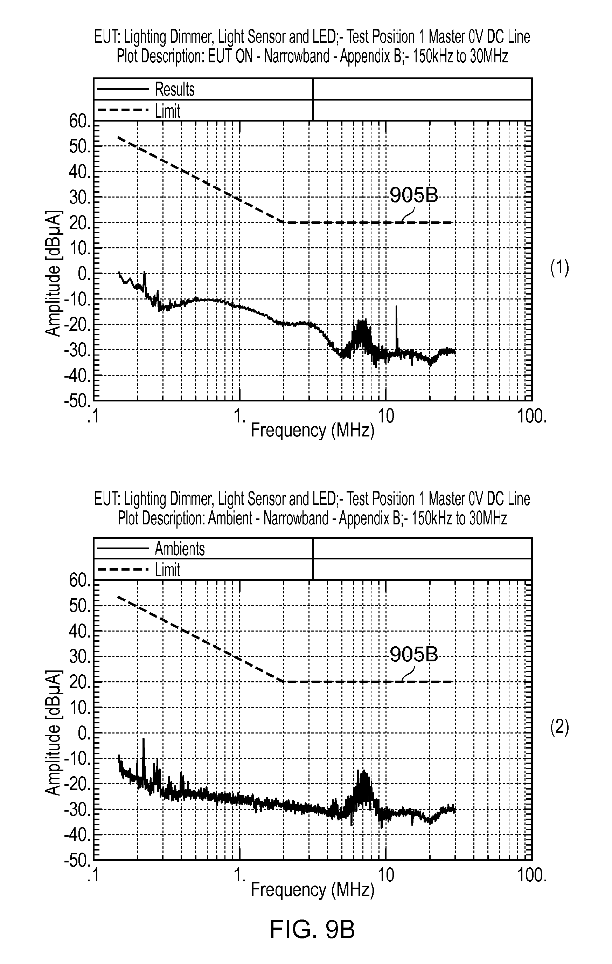

Figure 9B shows the electromagnetic interference within the band 150kHz to 30MHz for the device 100 in operation at 0V on the master line. In particular, Figure 9B (1) shows the EMI when the device is operational and Figure 9B(2) shows the EMI when the device is not operational. As can be seen, the EMI with the device 100 switched on is well below the permitted level marked by the dotted line 905B.

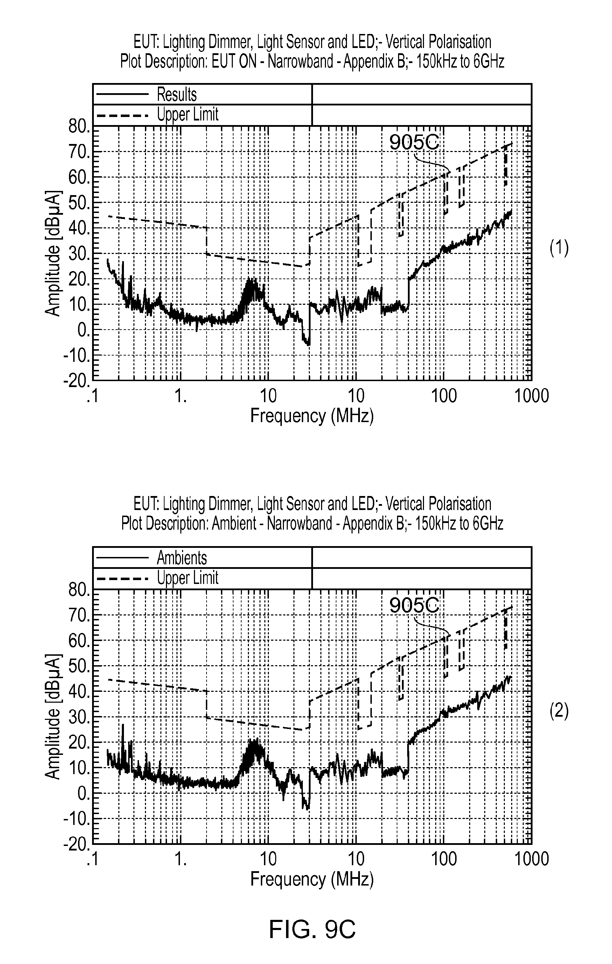

Figure 9C shows the electromagnetic interference within the band 150kHz to 6GHz for the device 100 in operation. In particular, Figure 9C (1) shows the EMI when the device is operational and Figure 9C(2) shows the EMI when the device is not operational. As can be seen, the EMI with the device 100 switched on is well below the permitted level marked by the dotted line 905C.

Although the foregoing has been described having the pulse width modulator switch 115 being connected to a light assembly, the invention is no way limited to this. In fact, the device 100 may be connected to any external electrical device.

Although the foregoing has been described as having a digital controller 110, the invention is not so limited. Specifically, the device 100 may instead have analogue components to control the pulse width modulator switch 115. This would further reduce electromagnetic interference because the digital controller 110 requires a clock which operates using a pulse train having substantially vertical rising and falling edges. However, it is envisaged that the clock may be disabled during periods of inactivity and may be enabled in response to an interrupt or after a predetermined period of time elapses. This is explained in relation to Figure 8.

In embodiments, the device 100 will be sealed by the manufacturer. This stops unauthorised tampering and is a safety feature. Again, for safety, it is desirable for the controller 110 to contain brownout detection circuitry which monitors the power supply. If the internal processor supply (which is normally 5V) drops below 4.64V, the system will automatically shut down safely. In the case of a shut-down, a power cycle will re-initialise the device 100. This brown-out detection circuitry ensures the controller 110 will shut down safely as the controller 110 can operate down to 2.7V.

Obviously, numerous modifications and variations of the present disclosure are possible in light of the above teachings. It is therefore to be understood that within the scope of the appended claims, the invention may be practiced otherwise than as specifically described herein.

For example, the pulse width modulator described above can be used to power any device located within an aircraft and not just the lighting system. For example, the pulse width modulator can be used to power the motors within seats.

Also the look up table described hereinbefore is only an example and any appropriate values can be used depending on the application of the pulse width modulator. This would be appreciated by the skilled person.

In so far as embodiments of the invention have been described as being implemented, at least in part, by a firmware-controlled data processing apparatus, it will be appreciated that a non-transitory machine-readable medium carrying such Firmware, such as an optical disk, a magnetic disk, semiconductor memory or the like, is also considered to represent an embodiment of the present invention.

## Claims

1. A pulse width modulator for use in avionics comprising an input operable to receive a direct current input and an output switch controlled to provide a pulse train having a duty cycle, whereby the output switch is configured such that each pulse within the pulse train has at least one of a sloping rising or falling edge.

2. A pulse width modulator according to claim 1 wherein when the predetermined duty cycle is changed to a second, different, duty cycle, the duty cycle is changed incrementally towards the second duty cycle.

3. A pulse width modulator according to claim 2, wherein each increment of change occurs at a predetermined period of time.

4. A pulse width modulator according to any preceding claim comprising a sensor input operable to receive data, from a sensor, and the duty cycle is determined in accordance with the received data.

5. A pulse width modulator according to claim 4, comprising a memory configured to store a look up table, wherein the look up table has the received data associated with the corresponding duty cycle.

6. A pulse width modulator according to either claim 4 or 5, wherein the received data is logarithmically associated with the corresponding duty cycle.

7. A pulse width modulator according to any preceding claim, comprising a transceiver operable to connect to a second pulse width modulator, the transceiver operable to provide to the second pulse width modulator data indicative of the duty cycle.

8. A pulse width modulator according to any preceding claim, comprising a transceiver operable to connect to a second pulse width modulator, the transceiver operable to receive from the second pulse width modulator data indicative of the duty cycle.

9. A pulse width modulator according to any preceding claim, comprising a controller and a clock, wherein the clock is configured to be enabled in response to either expiration of a predetermined period or an interrupt from a second device.

10. A system comprising a pulse width modulator according to any preceding claim connected to an electrical device

11. A system according to claim 10, wherein the electrical device is a light box comprising one or more lights.

12. A system according to claim 11, further comprising a light sensor connected to the pulse width modulator.

13. A method of performing pulse width modulation for use in avionics comprising receiving a direct current input and controlling an output switch to provide a pulse train having a duty cycle, whereby each pulse within the pulse train has at least one of a sloping rising or falling edge.

14. Firmware comprising microprocessor readable instructions which, when loaded onto a microprocessor, configures the microprocessor to perform the method of claim 13.
